(19)

**Europäisches Patentamt**

**European Patent Office**

**Office européen des brevets**

(11) **EP 4 012 926 B1**

(12) **EUROPÄISCHE PATENTSCHRIFT**

(45) Veröffentlichungstag und Bekanntmachung des Hinweises auf die Patenterteilung:
**29.01.2025 Patentblatt 2025/05**

(51) Internationale Patentklassifikation (IPC):
**H03K 17/082** *(2006.01)* **G01R 27/16** *(2006.01)*
**G01R 27/26** *(2006.01)* **H03K 17/0814** *(2006.01)*

(21) Anmeldenummer: **20212658.7**

(22) Anmeldetag: **09.12.2020**

(52) Gemeinsame Patentklassifikation (CPC):
**H03K 17/0828; G01R 27/16; G01R 27/2605; G01R 27/2611; H03K 17/08148**

(54) **GLEICHSTROMSCHALTER**

DIRECT CURRENT SWITCH

COMMUTATEUR À COURANT CONTINU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.06.2022 Patentblatt 2022/24**

(73) Patentinhaber: **Siemens Aktiengesellschaft 80333 München (DE)**

(72) Erfinder:
• **Handt, Karsten 92348 Berg (DE)**

• **Hänsel, Stefan 91056 Erlangen (DE)**

(74) Vertreter: **Siemens Patent Attorneys Postfach 22 16 34 80506 München (DE)**

(56) Entgegenhaltungen:
EP-A1- 1 643 256          WO-A1-2017/000996
WO-A1-2019/237221          CN-A- 106 896 275
JP-A- 2002 090 402          US-A1- 2020 124 657
US-A1- 2021 257 832

## Beschreibung

Die Erfindung betrifft einen Gleichstromschalter zur Auftrennung einer Gleichstrom-Leitung mit wenigstens einem im Strompfad der Gleichstrom-Leitung angeordneten Halbleiterschalter und einer Steuereinrichtung für den Halbleiterschalter.

Aufgrund ihrer Fähigkeit, DC-Ströme schnell und ohne entstehenden Lichtbogen abzuschalten, ist es technisch sinnvoll, Halbleiterschalter als Schalter für Gleichstromnetze einzusetzen. Typischerweise wird dabei der Halbleiterschalter direkt im Strompfad angeordnet. Im eingeschalteten Zustand übernimmt der Halbleiterschalter daher den vollen Laststrom und ist im Normalbetrieb dauerhaft eingeschaltet. Tritt ein Fehler im zu schützenden Netz auf, muss der Halbleiterschalter in der Lage sein, diesen Fehler abzuschalten.

Zwei Lasttypen sind dabei problematisch, nämlich kapazitive Lasten mit besonders kleinen oder besonders großen Zuleitungs-Induktivitäten. In Gleichstromnetzen mit kapazitiven Lasten ohne größere Zuleitungs-Induktivitäten ergeben sich sehr große Stromanstiegsgeschwindigkeiten. Sind diese so groß, dass bei einer gegebenen Abschaltverzögerung des Schalters (bedingt durch Totzeiten bei der Strommessung, Abschaltzeitverzug, etc.) der maximal beherrschbare Strom des Halbleiterschalters überschritten wird, kann dieser Halbleiterschalter den Fehler nicht mehr abschalten. Es kommt in der Folge zu einer Zerstörung des Gleichstromschalters. Deshalb sehen Gleichstromschalter eine minimale Zuleitungsinduktivität vor, die im Datenblatt angegeben ist.

Gleichstromnetze mit sehr großen Zuleitungs-Induktivitäten stellen das andere Extrem dar.

Hier ist nicht die Abschaltverzögerung des Schalters das begrenzende Element, sondern die in der Zuleitungsinduktivität gespeicherte Energie. Für den Abbau dieser Energie besitzen Gleichstromschalter üblicherweise ein Schutznetzwerk zur Überspannungsbegrenzung, hier auch als Entlastungsnetzwerk bezeichnet. Die in der Zuleitungs-Induktivität gespeicherte Energie wird dabei umgewandelt, beispielsweise in Wärme (bei Verwendung von Varistoren) oder gespeichert (beispielsweise in Kondensatoren). Da die Belastbarkeit des Entlastungsnetzwerks begrenzt ist, ist für Gleichstromschalter üblicherweise auch eine maximale Zuleitungs-Induktivität vorgesehen. Häufig ist in realen Anlagen unklar, welche Zuleitungsinduktivität verbaut ist. Dadurch ist auch unklar, welche Belastung bei Schaltvorgängen für einen Schalter zu erwarten ist. Die Belastung kann nur mit aufwendigen Messungen vor Ort oder mit Kurzschlusstests nach dem Prinzip Trial and Error festgestellt werden.

Ein Gleichstromschalter nach dem Oberbegriff von Anspruch 1 ist aus der WO 2019/237221 A1 bekannt.

Aufgabe der Erfindung ist es, einen Gleichstromschalter anzugeben, bei dem die eingangs genannten Nachteile vermindert sind. Insbesondere soll der Gleichstromschalter sicherstellen, dass er zerstörungsfrei abschalten kann. Diese Aufgabe wird durch einen Gleichstromschalter mit den Merkmalen von Anspruch 1 gelöst.

Der erfindungsgemäße Gleichstromschalter zur steuerbaren Trennung einer Gleichstrom-Leitung umfasst wenigstens einen im Strompfad der Gleichstrom-Leitung angeordneten Leistungshalbleiterschalter, Mittel zur Messung der Ein- und Ausgangsspannung, Mittel zur Messung des durch die Gleichstrom-Leitung fließenden Stroms und eine Steuereinrichtung für den Leistungshalbleiterschalter.

Die Steuereinrichtung ist ausgestaltet, den Gleichstromschalter für eine erste Zeitspanne einzuschalten, eine versorgungsseitig anliegende Eingangsspannung zu ermitteln, die zum Ende der ersten Zeitspanne vorliegende lastseitige Ausgangsspannung zu ermitteln, die zum Ende der ersten Zeitspanne vorliegende Stromstärke zu ermitteln und aus den ermittelten Werten eine anliegende Induktivität und/oder Kapazität zu ermitteln.

Dabei bezeichnet das Einschalten des Gleichstromschalters ein Schalten von einem sperrenden in einen leitenden Zustand des Gleichstromschalters. Dafür wird der Leistungshalbleiterschalter eingeschaltet, also seinerseits in den leitenden Zustand geschaltet.

Einer der Anschlüsse des Gleichstromschalters wird als versorgungsseitig bezeichnet. Damit ist die Seite gemeint, an der eine Spannungsversorgung angeschlossen ist, auf der also das anliegende Spannungsniveau im Normalfall nur wenig vom Schaltzustand des Gleichstromschalters beeinflusst wird. Die andere Seite wird als lastseitig bezeichnet und meint die Seite, an der ein Verbraucher wie beispielsweise ein über einen Umrichter gespeister Elektromotor angeschlossen ist. Das lastseitige Spannungsniveau kann dabei direkt vom Schaltzustand des Gleichstromschalters abhängen und auf Null fallen, wenn der Gleichstromschalters abgeschaltet ist.

Die Unterscheidung in lastseitig und versorgungsseitig dient der Verdeutlichung. In realen Gleichstromnetzen kann die Einbausituation komplexer sein. Beispielsweise können lastseitig mehrere Verbraucher und/oder Stromerzeuger angeschlossen sein. Versorgungsseitig kann ein ganzes Netz anderer Gleichstromschalter, Lasten und Stromerzeuger vorliegen. Die Einbausituation kann also sogar symmetrisch sein, womit eine Unterscheidung in versorgungsseitig und lastseitig nicht mehr möglich ist. Dann bezeichnen die beiden Begriffe die zwei Anschlussseiten des Gleichstromschalters und sind vertauschbar.

Für die Erfindung wurde erkannt, dass eine geeignete Steuersequenz für den Gleichstromschalter, die ein kurzes Einschalten des Gleichstromschalters umfasst, erlaubt, Messwerte aufzunehmen, die eine Bestimmung einer lastseitig vorliegenden Induktivität erlauben. Dafür wurde weiterhin erkannt, dass die nötige Ansteuerfähigkeit zum kurzen Einschalten und die nötigen Messeinrichtungen, nämlich eine Spannungsmesseinrichtung für die lastseitige Spannung und eine Strommesseinrichtung für den Stromfluss durch den Gleichstromschalter bei solchen Schaltern typischerweise ohnehin vorhanden sind. Vorteilhaft kann die Messung also bei entsprechend ausgestatteten Gleichstromschaltern sogar ohne bauliche Änderung vorgenommen werden. Ist der Steuereinrichtung die vorliegende wirksame, also lastseitige und verbraucherseitige Induktivität durch die Messung bekannt, kann der Gleichstromschalter vorteilhaft gesteuert werden, um mit dem Wert der Induktivität umzugehen und Zerstörungen zu vermeiden.

Vorteilhafte Ausgestaltungen des Gleichstromschalters gehen aus den abhängigen Ansprüchen hervor. Dabei kann die Ausführungsform nach einem der unabhängigen Ansprüche mit den Merkmalen eines der Unteransprüche oder vorzugsweise auch mit denen aus mehreren Unteransprüchen kombiniert werden. Demgemäß können für den Gleichstromschalter noch zusätzlich folgende Merkmale vorhanden sein:

Bei dem Leistungshalbleiterschalter handelt es sich typischerweise um einen IGBT. Es kann aber auch ein anderer Typ von Leistungshalbleiterschalter verwendet werden.

Der Gleichstromschalter kann zwei antiseriell geschaltete Leistungshalbleiterschalter umfassen. Dadurch ist der Gleichstromschalter bidirektional, also geeignet, einen Stromfluss unabhängig von der Stromflussrichtung abzuschalten. Umfasst der Gleichstromschalter dagegen nur einen Leistungshalbleiterschalter, kann üblicherweise nur ein Stromfluss einer Richtung abgeschaltet werden.

Die Steuereinrichtung kann ausgestaltet sein, als erste Zeitspanne eine vor dem Einschalten festgelegte Dauer zu verwenden. Der Gleichstromschalter wird also mit anderen Worten zu einem Einschaltzeitpunkt eingeschaltet und zu einem vorab festliegenden Abschaltzeitpunkt wieder ausgeschaltet. Die Entwicklung von Strom und Spannung spielt für die Dauer des Einschaltens in diesem Fall keine Rolle.

Die Steuereinrichtung kann auch ausgestaltet sein, die erste Zeitspanne zu verkürzen, wenn die Stromstärke einen Strom-Schwellwert erreicht. Der Gleichstromschalter wird also mit anderen Worten zu einem Einschaltzeitpunkt eingeschaltet und zu einem vorab nicht festliegenden Abschaltzeitpunkt wieder ausgeschaltet. Der Abschaltzeitpunkt ergibt sich in diesem Fall aus dem Verlauf des durch den Gleichstromschalter fließenden Stroms. Vorteilhaft wird dadurch eine Messung der anliegenden Induktivität genauer, da der Strom zum Abschaltzeitpunkt nicht beliebig klein sein kann. Zweckmäßig wird der Strom-Schwellwert groß genug gewählt, dass die vorliegenden Messungenauigkeiten nicht dominieren.

Voraussetzung für das Funktionieren in einem angemessenen Zeitrahmen ist aber, dass die anliegende Induktivität nicht zu groß ist, da ansonsten die erste Zeitspanne sehr groß werden kann. Daher ist es ferner zweckmäßig, für die erste Zeitspanne eine Maximaldauer zu verwenden, die die erste Zeitspanne nicht überschreitet, auch wenn die Stromstärke den Strom-Schwellwert nicht erreicht. In diesem Fall wird also sowohl eine vorab festgelegte Einschaltdauer verwendet als auch eine Abschaltung bei Erreich des Strom-Schwellwerts durchgeführt. Die Maximaldauer ist zweckmäßig kleiner als 1 ms, insbesondere kleiner als 10 $\mu$s.

Die Steuereinrichtung kann ausgestaltet sein, die anliegende Induktivität gemäß der folgenden Formel zu berechnen:

$$L_{zuleitung} = \frac{U \cdot t_{puls}}{I_{peak}}$$

Dabei bezeichnen:

- $L_{zuleitung}$ die Induktivität;
- U eine treibende Spannung;
- $t_{puls}$ die erste Zeitspanne und
- $I_{peak}$ die zum Ende der ersten Zeitspanne vorliegende Stromstärke.

Die treibende Spannung ist dabei in einer ersten Näherung die versorgungsseitig anliegende Spannung. In einer vorteilhaften Weiterbildung der Erfindung kann die Steuereinrichtung ausgestaltet sein, auch die lastseitig anliegende Spannung (hierin auch als Ausgangsspannung bezeichnet) zu ermitteln und zur Erhöhung der Genauigkeit von der versorgungsseitig anliegenden Spannung zur Ermittlung der treibenden Spannung abzuziehen.

Die Steuereinrichtung kann weiterhin ausgestaltet sein, zu ermitteln, ob eine Versorgungsspannung anliegt und ansonsten keine Messung vorzunehmen. Liegt keine Versorgungsspannung an, kann die Induktivität nicht ermittelt werden und alle Ergebnisse und Schlüsse, die aus einer Messung gezogen werden, sind ungültig.

Die Steuereinrichtung kann ausgestaltet sein, die zu Beginn der ersten Zeitspanne vorliegende Ausgangsspannung zu ermitteln. Dadurch kann die Messgenauigkeit erhöht werden, da sich die lastseitig anliegende Spannung während der Einschaltdauer deutlich ändern kann. Die Ausgangsspannung kann dann gemittelt werden.

Die Steuereinrichtung kann ausgestaltet sein, die ermittelte anliegende Induktivität mit einer maximal erlaubten Induktivität und einer minimal erlaubten Induktivität zu vergleichen und ein Signal auszugeben, das angibt, ob die ermittelte Induktivität zwischen den erlaubten Induktivitäten liegt. Dadurch wird vorteilhaft direkt am Gerät ersichtlich, ob die Einbausituation in Ordnung ist, ob also der Gleichstromschalter zu einer Abschaltung geeignet ist. Dadurch werden Einbausituationen, bei denen ein Abschalten zu einer Zerstörung des Gleichstromschalters führt, sofort ersichtlich und können korrigiert werden.

Die Steuereinrichtung kann ausgestaltet sein, die ermittelte Stromstärke beim Ausschaltzeitpunkt, also nach Verstreichen der ersten Zeitspanne, mit einem Schwellwert zu vergleichen und basierend auf dem Ergebnis des Vergleichs die anliegende Induktivität erneut zu ermitteln, wobei anstatt der ersten Zeitspanne eine zweite Zeitspanne verwendet wird, die länger ist als die erste Zeitspanne. Hierdurch kann sichergestellt werden, dass eine ausreichende Messgenauigkeit vorliegt, da nicht ein zu kleiner erreichter Stromwert aus der ersten Zeitspanne zur Bestimmung der Induktivität verwendet wird, sondern ein ausreichend großer Stromwert. Ist auch der erreichte Stromwert in der zweiten Zeitspanne zu gering, kann mit weiteren, größeren Zeitspannen fortgesetzt werden.

Die Steuereinrichtung kann ausgestaltet sein, eine Ermittlung der wirksamen Induktivität und/oder lastseitigen Kapazität vor jedem Einschaltvorgang durchzuführen. Dadurch wird erreicht, dass die Betriebssicherheit ständig gewährleistet bleibt, auch wenn Änderungen der Einbausituation oder der Lasten auftreten. Dabei ist vorteilhaft, dass die Zeitspannen, die für die Messung verwendet werden, im µs bis ms-Bereich liegen und somit auch eine Mehrzahl von Messungen das Einschalten nur unwesentlich verzögern.

Zur weiteren Erhöhung der Messgenauigkeit kann die Steuereinrichtung ausgestaltet sein, die Ermittlung der anliegenden Induktivität mehrfach durchzuführen und eine gemittelte Induktivität zu bestimmen. Dadurch werden Rausch-Anteile der Messungen im Ergebnis reduziert.

Ferner kann die Steuereinrichtung ausgestaltet sein, die lastseitig wirksame Kapazität zu bestimmen. Dies ist vorteilhaft, da diese vor einem Zuschalten des Gleichstromschalters vorgeladen werden muss. Der Schalter ist üblicherweise für eine maximal zulässige Kapazität ausgelegt. Die Steuereinrichtung führt dazu bereits vor der eigentlichen Vorladung einen Test durch, ob die lastseitig wirksame Kapazität die Auslegungsgrenze überschreitet.

Sowohl bei dem Einschaltvorgang für die Bestimmung der Induktivität auch für die Bestimmung der Kapazität kann ein im Gleichstromschalter vorhandener Vorladewiderstand zugeschaltet werden. In diesem Fall werden nicht der oder die Leistungshalbleiterschalter, die im Hauptstrompfad angeordnet sind, leitend geschaltet, sondern ein weiterer Schalter, der seriell zum Vorladewiderstand angeordnet ist. Da der Vorladewiderstand strombegrenzend wirkt, kann in diesem Fall die Einschaltdauer länger gewählt werden als bei einem Einschaltvorgang unter Verwendung der Leistungshalbleiterschalter im Hauptstrompfad.

Alternativ kann der Einschaltvorgang aber eben auch mit den Leistungshalbleiterschaltern im Hauptstrompfad vorgenommen werden.

Die Steuereinrichtung kann ausgestaltet sein, die lastseitig anliegende Kapazität gemäß der Formel zu berechnen:

Dabei sind:

$$C_{load} = \frac{Q_{load1} + Q_{load2}}{\Delta U_{out}}$$

- $C_{load}$ die Kapazität;
- $Q_{load1}$ eine lastseitig im verbundenen Zustand eingetragene Ladungsmenge;
- $Q_{load2}$ eine lastseitig nach dem Schalten in den getrennten Zustand eingetragene Ladungsmenge und
- $\Delta U_{out}$ die sich durch die eingetragenen Ladungsmengen ergebende Änderung der Ausgangsspannung.

Die eingetragenen Ladungsmengen können gemäß den folgenden Formeln ermittelt werden:

$$Q_{load1} = \frac{i_{peak} \cdot \left(t_{off} - t_0\right)}{2}$$

$$Q_{load2} = \frac{i_{peak} \cdot \left(t_1 - t_{off}\right)}{2}$$

Dabei sind:

- $t_0$ ein Einschaltzeitpunkt;
- $t_{off}$ ein Ausschaltzeitpunkt und

- t$_1$ ein Zeitpunkt, zu dem die Stromstärke nach dem Abschalten wieder null erreicht.

Es wird also bevorzugt für die Bestimmung der Kapazität auch die Zeit nach dem Abschalten berücksichtigt, in der der Stromfluss noch nicht wieder auf 0 A abgefallen ist.

Die Steuereinrichtung kann dabei ausgestaltet sein, die eingetragenen Ladungsmengen durch numerische Integration der Stromstärke zu ermitteln.

Die Steuereinrichtung kann ausgestaltet sein, die ermittelte lastseitig anliegende Kapazität mit einer maximal erlaubten Kapazität zu vergleichen und ein Signal auszugeben, das angibt, ob die ermittelte Kapazität größer als die maximal erlaubte Kapazität ist. Hierdurch wird sichergestellt, dass sofort erkennbar wird, wenn die lastseitig angeschlossene Kapazität die Vorladefähigkeit des Gleichstromschalters überschreitet.

Im Folgenden wird die Erfindung anhand der Figuren der Zeichnung im Zusammenhang mit einem Ausführungsbeispiel näher beschrieben und erläutert. Dabei zeigen

Figur 1 ein Gleichstromnetzwerk mit einem versorgungsseitigen Teil und einem lastseitigen Teil, wobei die Teile von einem DC-Schalter verbunden werden,

Figur 2 den DC-Schalter mit Leistungshalbleiterschaltern,

Figur 3 ein Diagramm, das einen vom DC-Schalter durchgeführten Messzyklus angibt.

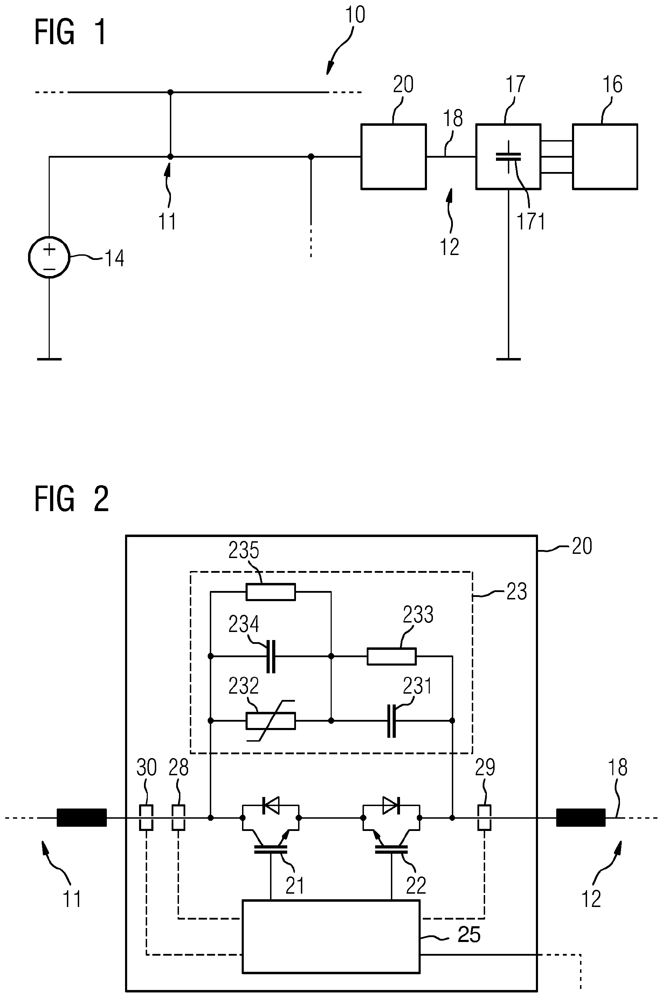

Figur 1 zeigt ein Gleichstromnetzwerk 10. Das Gleichstromnetzwerk 10 ist durch einen DC-Schalter 20 in einen versorgungsseitigen Teil 11 und einen lastseitigen Teil 12 aufgeteilt. Im vorliegenden Beispiel umfasst der versorgungsseitige Teil 11 eine DC-Spannungsquelle 14, die eine beispielhafte Spannung von 650 V bereitstellt. Diese Spannung liegt eingangsseitig am DC-Schalter 20 an.

Der lastseitige Teil 12 umfasst eine Last in Form eines Elektromotors 16, dem ein Wechselrichter 17 vorgeschaltet ist. Der Wechselrichter 17 wiederum umfasst einen Gleichspannungs-Zwischenkreis mit einem Kondensator 171 und parallel zum Kondensator 171 geschalteten Halbbrücken, mittels derer aus der anliegenden Gleichspannung eine dreiphasige Betriebsspannung für den Elektromotor 16 erzeugt wird.

Die Last aus Wechselrichter 17 und Elektromotor 16 tritt für den DC-Schalter 20 durch den Kondensator 171, der den Gleichspannungs-Zwischenkreis ausmacht, als kapazitive Last in Erscheinung. Die Zuleitung 18 zwischen dem DC-Schalter 20 und dem Wechselrichter 17 wiederum weist eine Induktivität auf. Wie eingangs beschrieben, muss die Induktivität der Zuleitung 18 typischerweise in einem vorab bekannten Bereich zwischen einer minimalen und einer maximalen Induktivität liegen, beispielsweise zwischen 4 μH und 80 μH, um eine sichere Abschaltung durch den DC-Schalter 20 zu gewährleisten. Auch die Kapazität des Kondensators 171 darf einen maximalen Kapazitätswert, beispielsweise 40 mF, nicht überschreiten, da ansonsten der DC-Schalter 20 die Vorladung des Kondensators 171 nicht sicher vornehmen kann.

Figur 2 zeigt den DC-Schalter 20, der eine beispielhafte Ausführungsform der Erfindung ist, genauer. Der DC-Schalter 20 umfasst zwei antiseriell geschaltete Leistungshalbleiterschalter 21, 22, beispielsweise IGBTs, mit ihren üblicherweise im Modul bereits verbauten Freilaufdioden. Die Leistungshalbleiterschalter 21, 22 sind seriell in den Strompfad des Gleichspannungsnetzwerks 10 eingebunden. Sie tragen also im eingeschalteten Zustand des DC-Schalters 20 den gesamten Laststrom und bewirken direkt die Abschaltung des Stromflusses und das Sperren der anliegenden Versorgungsspannung. Der DC-Schalter 20 kann mit den zwei Leistungshalbleiterschaltern 21, 22 Ströme in beide Richtungen abschalten. In anderen Ausgestaltungen kann der DC-Schalter 20 auch nur einen einzelnen Leistungshalbleiterschalter aufweisen, wodurch die Abschaltfähigkeit aber auf eine Stromrichtung beschränkt ist.

Parallel zu den Leistungshalbleiterschaltern 21, 22 umfasst der DC-Schalter 20 ein Entlastungsnetzwerk 23. Das beispielhafte Entlastungsnetzwerk 23 ist parallel zu den beiden Leistungshalbleiterschaltern 21, 22 geschaltet. Es umfasst eine erste Serienschaltung aus einem Kondensator 231 und einem Varistor 225. Der ersten Serienschaltung parallel geschaltet ist eine zweite Serienschaltung mit einem Widerstand 233 und einem zweiten Kondensator 234. Dem zweiten Kondensator 234 parallel geschaltet ist ein zweiter Widerstand 235. Der Mittelpunkt der ersten und zweiten Serienschaltung ist verbunden.

Der DC-Schalter 20 weist eine in Figur 2 nicht dargestellte Vorladeschaltung auf, die eine Ladung von lastseitig angeschlossenen Kapazitäten erlaubt und dabei durch einen seriell geschalteten Widerstand den fließenden Strom begrenzt, um die fälschliche Detektion eines Kurzschlusses und die folgende ungewollte Abschaltung zu vermeiden.

Auf der Eingangsseite umfasst der DC-Schalter 20 eine Messeinrichtung 28 zur Messung der Eingangsspannung, also der Versorgungsspannung im Gleichspannungsnetzwerk 10. Die Versorgungsspannung beträgt in diesem Beispiel 650 V. Auf der Ausgangsseite umfasst der DC-Schalter 20 eine Messeinrichtung 29 zur Messung der Ausgangsspannung. Die Messeinrichtungen 28, 29 sind in diesem Ausführungsbeispiel als Spannungsteiler mit Sigma-Delta-Wandler aufgebaut. Im abgeschalteten Zustand und ausreichend lange nach dem letzten Abschalten beträgt diese im Allgemeinen 0 V, während sie ausreichend lange nach einem Einschalten, also im laufenden Betrieb der Last nahezu der Eingangsspannung entspricht, wobei der Unterschied zur Eingangsspannung der Spannungsabfall über die beiden leitenden Leistungshalbleiterschalter 21, 22 ist. Der DC-Schalter 20 umfasst weiterhin eine Messeinrichtung 30 zur Ermittlung des aktuellen Stromflusses durch den DC-Schalter 20. Die Messeinrichtung 30 ist beispielsweise als magnetoresistiver Stromsensor ausgeführt.

Die Messeinrichtungen 28...30 sind mit einer Steuereinrichtung 25 verbunden, die die ermittelten Signale aufnimmt und verarbeitet. Die Steuereinrichtung 25 steuert weiterhin auch die Leistungshalbleiterschalter 21, 22 durch Signale an deren jeweiligen Gate-Anschluss. Die Steuereinrichtung 25 ist dazu mit einer übergeordneten Steuerung verbunden und schaltet auf deren Signale hin die Leistungshalbleiterschalter 21, 22 ein, also leitend, und aus. In diesem Text wird der DC-Schalter 20 als abgeschaltet oder ausgeschaltet bezeichnet, wenn die beiden Leistungshalbleiterschalter 21, 22 abgeschaltet, also nicht-leitend geschaltet sind. Der DC-Schalter 20 wird als eingeschaltet bezeichnet, wenn die beiden Leistungshalbleiterschalter 21, 22 eingeschaltet, also leitend, sind. Weiterhin ist die Steuereinrichtung 25 auch ausgestaltet, unter bestimmten Umständen selbsttätig eine Abschaltung vorzunehmen. Das kann beispielsweise dann erforderlich sein, wenn ein lastseitiger Kurzschluss festgestellt wird.

Häufig sind bei realen Gleichstromnetzwerken 10 die Werte für die Kapazität einer Last, also hier die Kapazität des Kondensators 171 und die Länge und Induktivität der Zuleitung 18 unbekannt. Überschreitet die Induktivität der Zuleitung 18 einen bestimmten für den DC-Schalter 20 bekannten Wert, kann das Entlastungsnetzwerk 23 die auftretende Überspannung nach einer Abschaltung nicht mehr ausreichend begrenzen. Eine Zerstörung der Leistungshalbleiterschalter 21, 22 kann daher nicht mehr ausgeschlossen werden. Weiterhin ist der DC-Schalter 20 nur für die Vorladung einer maximalen Lastkapazität ausgelegt, die daher ebenfalls eingehalten werden muss.

Sind die Werte für Induktivität und Kapazität unbekannt, kann die Betriebssicherheit nur durch zusätzlichen Aufwand gewährleistet werden, beispielsweise durch Abschätzung oder manuelle Messung der erforderlichen Werte.

Um dieser Problematik zu begegnen, ist die Steuereinrichtung 25 weiterhin ausgestaltet, auf einen Trigger hin, beispielsweise einen Tastendruck am Gerät oder ein elektronisch übermitteltes Signal, beispielsweise von einem Tablet-PC, einen Testvorgang durchzuführen.

Der Testvorgang setzt voraus, dass der DC-Schalter 20 abgeschaltet ist und eine Versorgungsspannung eingangsseitig anliegt. Ist das der Fall, schaltet die Steuereinrichtung 25 den DC-Schalter 20 zu einem Einschaltzeitpunkt für eine erste Zeitspanne an und nach Ablauf der ersten Zeitspanne zu einem Abschaltzeitpunkt wieder aus. Die erste Zeitspanne wird dabei sehr kurz gewählt, beispielsweise 4 µs.

Zumindest zum Abschaltzeitpunkt wird die Stromstärke des durch den DC-Schalter 20 fließenden Stroms sowie die Ausgangsspannung ermittelt. Zusätzlich kann auch der Verlauf des Stroms zwischen dem Einschaltzeitpunkt und dem Ausschaltzeitpunkt ermittelt und aufgezeichnet werden. Ebenso kann zusätzlich die Ausgangsspannung zum Einschaltzeitpunkt ermittelt werden.

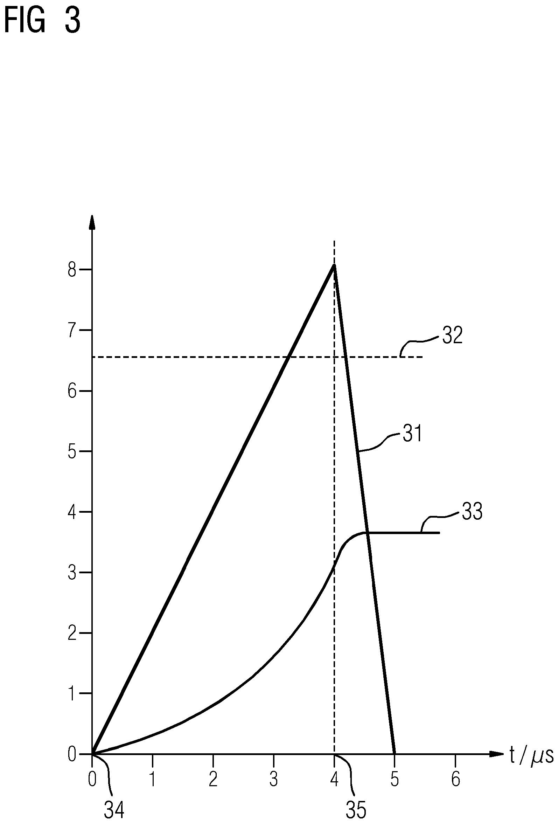

Figur 3 zeigt einen beispielhaften Verlauf der Stromstärke 31 in A, der Versorgungsspannung 32 und der Ausgangsspannung 33 für einen solchen Testvorgang. Zum Einschaltzeitpunkt 34, der hier der Einfachheit halber auf die Zeit t = 0 gelegt ist, wird der DC-Schalter 20 eingeschaltet und zum Ausschaltzeitpunkt 35 wieder abgeschaltet. Die Versorgungsspannung 32 ist längerfristig gleichbleibend und wird über den dargestellten kurzen Zeitraum konstant sein. Die Stromstärke steigt durch die Induktivität nicht direkt auf den Maximalwert, sondern steigt stattdessen an. Dieser Anstieg ist allgemein nichtlinear. Da der Strom aber in der kurzen ersten Zeitspanne nur einen kleinen Bruchteil seines Maximalwerts erreicht, ist der Anstieg in dieser Zeit praktisch linear. Nach dem Abschaltzeitpunkt fällt der Strom - ebenfalls mit einer endlichen Stromänderungs-Geschwindigkeit - wieder auf Null. Die Ausgangsspannung steigt in dieser Zeit ebenfalls linear an, wobei der erreichte Wert zum Abschaltzeitpunkt klein gegenüber der Eingangsspannung ist.

Aus dem allgemein bekannten Zusammenhang zwischen der Spannung U, der Induktivität L, dem Strom i und der Zeit t

$$U = L\frac{di}{dt}$$

kann unter Verwendung der im Testvorgang ermittelten Größen die anliegende Induktivität $L_{Zuleitung}$ der Zuleitung 18 ermittelt werden. Dazu wird die Formel umgestellt zu

$$L_{zuleitung} = \frac{U \cdot t_{puls}}{I_{peak}}$$

Dabei bezeichnet $t_{puls}$ die Einschaltzeitdauer, also die erste Zeitspanne. $I_{peak}$ ist die zum Ausschaltzeitpunkt vorliegende Stromstärke und U die treibende Spannung. In einer vereinfachten Variante kann als treibende Spannung die Größe der Versorgungsspannung 32 verwendet werden. Diese Vereinfachung stellt nur einen geringen Fehler dar, solange die sich während der ersten Zeitspanne ergebende Ausgangsspannung klein gegenüber der Eingangsspannung bleibt. In diesem Fall kann die Induktivität bei Kenntnis der Eingangsspannung, der Stromstärke beim Abschaltzeitpunkt und der Länge der ersten Zeitspanne bestimmt werden.

Eine genauere Bestimmung kann erfolgen, indem die treibende Spannung gemäß der folgenden Methode bestimmt wird:

$$U = U_{in} - \left( U_{out_0} + \frac{U_{out_1} - U_{out_0}}{2} \right) = U_{in} - \frac{U_{out_0} + U_{out_1}}{2}$$

Dabei sind $U_{in}$ die Versorgungsspannung, $U_{out0}$ die zum Einschaltzeitpunkt vorliegende Ausgangsspannung und $U_{out1}$ die zum Ausschaltzeitpunkt vorliegende Ausgangsspannung.

Unter der Annahme von beispielhaften Werten, wie sie in Figur 3 ersichtlich sind, von 650 V für die Versorgungsspannung, 4 μs für die erste Zeitspanne, 0 V für $U_{out0}$ und 3 V für $U_{out1}$ ergibt sich

$$L_{zuleitung} = \frac{(650V - 3V \, / \, 2) \cdot 4\mu s}{8A} \approx 254\mu H$$

für die anliegende Induktivität der Zuleitungen.

Die sich in den Messungen ergebenden Werte für die Stromstärke und die Ausgangsspannungen hängen von der Versorgungsspannung, der Induktivität und der gewählten Zeitdauer ab. Bei bestimmten Kombinationen dieser Werte, beispielsweise bei sehr hoher Induktivität oder sehr kurz gewählter Zeitdauer sind die Messwerte zu klein und daher zu ungenau, um die Induktivität zuverlässig zu bestimmen.

Für diese Fälle ist die Steuereinrichtung 25 ausgestaltet, die gemessene Stromstärke mit einem Schwellwert zu vergleichen. Unterschreitet die Stromstärke den Schwellwert, wird eine erneute Messung durchgeführt, wobei als Einschaltzeitdauer, also als Abstand zwischen Einschaltzeitpunkt und Ausschaltzeitpunkt, eine zweite Zeitspanne verwendet wird, die länger ist als die erste Zeitspanne. Beispielsweise kann für die erneute Messung eine Zeitdauer von 6 μs verwendet werden.

Die Steuereinrichtung 25 kann insbesondere ausgestaltet sein, die verwendete Einschaltdauer so lange in Schritten von beispielsweise 2 μs zu erhöhen, bis die gemessene Stromstärke den Schwellwert überschreitet oder bis eine maximale Einschaltdauer erreicht ist. Überschreitet die erreichte Stromstärke den Schwellwert, kann das Messergebnis verwendet werden und die Induktivität der Zuleitungen bestimmt werden. Da die einzelne Messung sehr kurz ist, benötigt selbst eine Vielzahl von Messungen eine Zeit von weniger als 1 ms. Daher kann auch anstelle einer ersten Zeitspanne von 4 μs eine so kurze erste Zeitspanne verwendet werden, beispielsweise 500 ns, dass in jedem Fall nur eine sehr geringe Stromstärke erreicht wird. Damit ist selbst für außergewöhnliche Einbau-Situationen gewährleistet, dass der Testvorgang keine Beschädigung bewirkt und in nachfolgenden längeren Messungen wird dann eine Stromstärke erreicht, die eine Bestimmung der Induktivität erlaubt.

Das Ergebnis kann weiterverarbeitet werden, beispielsweise indem die ermittelte Induktivität elektronisch übermittelt oder direkt an einem Display ausgegeben wird. Alternativ kann auch ein Vergleich mit im DC-Schalter 20 hinterlegten Werten für die maximale und minimale Induktivität für die Zuleitungen 18 durchgeführt werden. Liegt die ermittelte Induktivität zwischen der minimalen und maximalen Induktivität, kann ein Signal ausgegeben werden, das einer positiven Meldung entspricht, beispielsweise durch Leuchten einer grünen LED. Im anderen Fall kann ein Warnsignal ausgegeben werden. Weiterhin kann die Steuereinrichtung 25 ausgestaltet sein, im Falle eines negativen Ergebnisses ein Einschalten des DC-Schalters 20 für den aktiven Betrieb zu verhindern.

Wird die maximale Einschaltdauer erreicht, ist entweder die wirksame Induktivität zu groß und somit ein Betrieb nicht möglich oder aber die Eingangsspannung zu gering. Die Induktivität kann also nicht oder nur zu ungenau bestimmt werden und es kann wiederum ein Warnsignal ausgegeben werden und das Einschalten des DC-Schalters 20 kann verhindert werden.

Um eine weiter verbesserte Genauigkeit der Messung zu bewirken, kann die Steuereinrichtung 25 in bestimmten Ausführungsformen des DC-Schalters 20 ausgestaltet sein, die Messung ohne Änderung der Einstellungen, insbesondere der Einschaltdauer, zu wiederholen. Die gesammelten und gespeicherten Ergebnisse können dann gemittelt werden, um den Einfluss von Schwankungen in den Messergebnissen zu verringern.

Generell sind die Messeinrichtungen zur Bestimmung von Ein- und Ausgangsspannung und Stromstärke auf die Nennwerte des DC-Schalters 20 ausgelegt und liefern daher bei den verhältnismäßig geringen Werten, die im Rahmen der Testvorgänge erreicht werden, ungenaue Ergebnisse.

Daher ist in dem hier beschriebenen Ausführungsbeispiel die Steuereinrichtung 25 weiterhin ausgestaltet, in dem Fall, dass die Induktivität der Zuleitungen 18 wenigstens so groß ist wie die minimale Induktivität, einen zweiten Testvorgang durchzuführen. Da die Induktivität der Zuleitungen 18 ausreichend groß ist, muss eine möglichst kurze Einschaltdauer zur Vermeidung von zu großen Strömen nicht mehr so intensiv beachtet werden. Daher kann beim zweiten Testvorgang Wert darauf gelegt werden, eine Mindeststromstärke zu erreichen, um eine genauere Bestimmung der Induktivität zu ermöglichen.

Bei dem zweiten Testvorgang wird daher im Gegensatz zum ersten Testvorgang nicht die Einschaltdauer, sondern die Stromstärke vorgegeben. Diese vorgegebene Stromstärke kann so gewählt werden, dass Messungenauigkeiten nur noch eine untergeordnete Rolle spielen. Mittels der Eingangs- und Ausgangsspannungen vor dem Test kann eine Stromstärke berechnet werden, die bei der maximalen Induktivität der Zuleitungen in einer dritten Zeitspanne zu erwarten ist. Dieser Wert wird als Referenzwert in einer Vergleichseinheit, beispielsweise einem Komparator hinterlegt. Dies hat auch den Vorteil, dass der Referenzwert unter Umständen genauer eingestellt werden kann als die Strommessung selbst ist. Nun wird der DC-Schalter 20 maximal für die dritte Zeitspanne eingeschaltet. Erreicht der Strom bereits vor Ablaufen der dritten Zeitspanne den berechneten Wert, wird der DC-Schalter 20 sofort abgeschaltet und die verstrichene Einschaltdauer gespeichert. Wird der berechnete Wert für die Stromstärke nicht erreicht, wird der erreichte Stromwert als Ergebnis verwendet.

In beiden Fällen kann die bereits eingeführte Formel (2) angewandt werden. Erreicht der Strom bereits vor Ablaufen der dritten Zeitspanne den berechneten Wert, wird die verstrichene Einschaltdauer als Wert für die Zeit t verwendet. Andernfalls wird der ermittelte maximale Stromwert verwendet.

In anderen möglichen Ausgestaltungen des DC-Schalters 20 ist die Steuereinrichtung 25 ausgestaltet, den zweiten Testvorgang ohne vorheriges Durchführen des ersten Testvorgangs auszuführen.

Die Steuereinrichtung 25 ist weiterhin ausgestaltet, eine Überprüfung der angeschlossenen Kapazität und einen Vergleich mit einer gespeicherten maximal zulässigen Vorladekapazität durchzuführen. Diese ist zumindest bei Verwendung eines Vorladewiderstandes ebenfalls limitiert. Der Wert der maximal zulässigen Vorladekapazität ist dafür in der Steuereinrichtung 25 gespeichert.

Dazu werden die Zusammenhänge

$$Q = \int_{t0}^{t1} i\, dt$$

und

$$C = \frac{Q}{U}$$

verwendet, wobei Q die Ladungsmenge und C die Kapazität ist. Unter der Annahme, dass die Versorgungsspannung deutlich größer als die Ausgangsspannung ist, die sich während der Einschaltdauer ergibt, kann der Verlauf der Stromstärke, wie er in Figur 3 dargestellt ist, in zwei Bereiche mit annähernd linearem Verlauf aufgeteilt werden, um die Berechnung des Integrals zu vereinfachen. Der erste Bereich ist dabei die Einschaltdauer selbst, also beispielsweise die erste Zeitspanne. Der zweite Bereich erstreckt sich vom Abschaltzeitpunkt bis zu dem Zeitpunkt, zu dem die Stromstärke wieder 0 erreicht. Die eingeprägte Ladungsmenge kann dann mit der oben genannten Formel wie folgt berechnet werden:

Erster Bereich:

$$Q_{load1} = \frac{i_{peak} \cdot (t_{off} - t_0)}{2} = \frac{8A \cdot (4\mu s - 0)}{2} = 16\mu As$$

Zweiter Bereich:

$$Q_{load1} = \frac{i_{peak} \cdot (t_1 - t_{off})}{2} = \frac{8A \cdot (5\mu s - 4\mu s)}{2} = 4\mu As$$

Die sich ergebende Gesamtladungsmenge ist die Summe der beiden Anteile, also 20 pAs. Alternativ zu einer Berechnung mittels zweier näherungsweise linearer Bereiche kann in einer Umsetzung in einem Mikrocontroller auch ein numerisches Integrationsverfahren verwendet werden, um die eingebrachte Ladungsmenge zu bestimmen. Dann erübrigt sich die Aufteilung in zwei Bereiche.

Die Lastkapazität kann aus der Ladungsmenge nun mittels Formel (5) bestimmt werden:

$$C_{load} = \frac{Q_{load1} + Q_{load2}}{\Delta U_{out}} = \frac{20\mu As}{3V} = 6{,}7\mu F$$

Durch Vergleich es ermittelten Werts für die angeschlossene Kapazität mit der maximal zulässigen Vorladekapazität ermittelt die Steuereinrichtung 25, ob es überhaupt zulässig ist, die Vorladung einzuschalten. Für den positiven und den negativen Fall kann die Steuereinrichtung 25 wiederum ausgestaltet sein, ein Signal elektronisch auszugeben oder direkt sichtbar anzuzeigen. Weiterhin kann die Steuereinrichtung 25 wiederum ausgestaltet sein, ein Einschalten zu verhindern, wenn die maximal zulässige Vorladekapazität überschritten wird.

Der beschriebene DC-Schalter 20 stellt also zerstörungsfrei sicher, dass die installierte Zuleitungsinduktivität größer ist als die minimale zulässige Zuleitungsinduktivität und kleiner ist als die maximal zulässige. Weiterhin stellt er auch sicher, dass die installierte Lastkapazität kleiner ist als die maximal zulässige Vorladekapazität. Dazu sind vorteilhaft keine aufwendigen manuellen Messungen oder Prüfungen nötig.

Über eine pure Rückmeldung zur Installationszeit hinaus kann der DC-Schalter 20 auch im laufenden Betrieb ein Einschalten verhindern, wenn sich dadurch ein unsicherer Betriebszustand ergeben würde. Dafür ist es vorteilhaft auch möglich, dass die beschriebenen Testvorgänge und die Bestimmung der lastseitig angeschlossenen Werte nicht nur bei der Inbetriebnahme, sondern auch im laufenden Betrieb vorgenommen wird.

Die Steuereinrichtung 25 kann dafür ausgestaltet sein, vor jedem Einschaltvorgang, der beispielsweise durch eine übergeordnete Steuerung verlangt wird, die Bestimmung der angeschlossenen Induktivität und/oder Kapazität vorzunehmen. Dabei ist von Vorteil, dass diese Bestimmung selbst bei einer Durchführung von mehreren Testvorgängen mit unterschiedlichen Zeitspannen nur sehr wenig Zeit in Anspruch nimmt, insbesondere weniger als 1 ms und daher vor dem Einschalten auch im laufenden Betrieb durchgeführt werden kann. Werden die dem DC-Schalter 20 bekannten erlaubten Wertbereiche nicht eingehalten, findet der Einschaltvorgang nicht statt und der DC-Schalter 20 gibt eine Fehlermeldung aus.

Bezugszeichenliste

| | |
|---|---|
| 10 | Gleichspannungsnetzwerk |
| 11 | Versorgungsseitiger Teil |
| 12 | Lastseitiger Teil |
| 14 | Spannungsquelle |
| 16 | Elektromotor |
| 17 | Wechselrichter |
| 18 | Zuleitung |
| 20 | DC-Schalter |
| 21, | 22 Leistungshalbleiterschalter |
| 23 | Entlastungsnetzwerk |
| 231, 234 | Kondensator |
| 225 | Varistor |
| 233,235 | Widerstand |
| 28, 29, 30 | Messeinrichtungen |
| 25 | Steuereinrichtung |
| 31 | Stromstärke |
| 32 | Versorgungsspannung |
| 33 | Ausgansspannung |
| 34 | Einschaltzeitpunkt |
| 35 | Abschaltzeitpunkt |

**Patentansprüche**

**1.** Gleichstromschalter (20) zur Auftrennung einer Gleichstrom-Leitung (18), umfassend

- wenigstens einen im Strompfad der Gleichstrom-Leitung (18) angeordneten Leistungshalbleiterschalter (21, 22),

- Mittel (28, 29) zur Messung der Ein- und Ausgangsspannung (32, 33) des Gleichstromschalters (20),
- Mittel (30) zur Messung des durch die Gleichstrom-Leitung (18) fließenden Stroms (31),
- eine Steuereinrichtung (25) für den Leistungshalbleiterschalter (21, 22),

**dadurch gekennzeichnet, dass** die Steuereinrichtung (25) ausgestaltet ist,

- den Gleichstromschalter (20) für eine erste Zeitspanne einzuschalten,
- die anliegende Eingangsspannung (32) zu ermitteln,
- die zum Ende der ersten Zeitspanne vorliegende Ausgangsspannung (33) zu ermitteln,
- die zum Ende der ersten Zeitspanne vorliegende Stromstärke (31) zu ermitteln,
- aus den ermittelten Werten eine anliegende Induktivität und/oder lastseitig anliegende Kapazität zu ermitteln.

2. Gleichstromschalter (20) nach Anspruch 1, bei dem die Steuereinrichtung (25) ausgestaltet ist, als erste Zeitspanne eine vor dem Einschalten festgelegte Dauer zu verwenden.

3. Gleichstromschalter (20) nach Anspruch 1, bei dem die Steuereinrichtung (25) ausgestaltet ist, die erste Zeitspanne zu verkürzen und den Gleichstromschalter (20) auszuschalten, wenn die Stromstärke (31) einen Strom-Schwellwert erreicht.

4. Gleichstromschalter (20) nach einem der vorangehenden Ansprüche, bei dem die Steuereinrichtung (25) ausgestaltet ist, aus den ermittelten Werten die anliegende Induktivität zu ermitteln und die anliegende Induktivität gemäß der Formel

$$L_{zuleitung} = \frac{U \cdot t_{puls}}{I_{peak}}$$

zu berechnen, wobei $L_{zuleitung}$ die Induktivität, U eine aus Ein- und/oder Ausgangsspannung ermittelte treibende Spannung, $t_{puls}$ die erste Zeitspanne und $I_{peak}$ die zum Ende der ersten Zeitspanne vorliegende Stromstärke ist.

5. Gleichstromschalter (20) nach einem der vorangehenden Ansprüche, bei dem die Steuereinrichtung (25) ausgestaltet ist, zu ermitteln, ob eine Eingangsspannung (32) anliegt.

6. Gleichstromschalter (20) nach einem der vorangehenden Ansprüche, bei dem die Steuereinrichtung (25) ausgestaltet ist, die zu Beginn der ersten Zeitspanne vorliegende Ausgangsspannung (33) zu ermitteln.

7. Gleichstromschalter (20) nach einem der vorangehenden Ansprüche, bei dem die Steuereinrichtung (25) ausgestaltet ist, eine Ermittlung der anliegenden Induktivität und/oder Kapazität vor jedem Einschaltvorgang durchzuführen.

8. Gleichstromschalter (20) nach einem der vorangehenden Ansprüche, bei dem die Steuereinrichtung (25) ausgestaltet ist, aus den ermittelten Werten die anliegende Induktivität zu ermitteln und die ermittelte Stromstärke (31) mit einem Schwellwert zu vergleichen und bei basierend auf dem Ergebnis des Vergleichs die anliegende Induktivität erneut zu ermitteln, wobei anstatt der ersten Zeitspanne eine zweite Zeitspanne verwendet wird, die länger ist als die erste Zeitspanne.

9. Gleichstromschalter (20) nach einem der vorangehenden Ansprüche, bei dem die Steuereinrichtung (25) ausgestaltet ist, aus den ermittelten Werten die anliegende Induktivität zu ermitteln und die ermittelte anliegende Induktivität mit einer maximal erlaubten Induktivität und einer minimal erlaubten Induktivität zu vergleichen und ein Signal auszugeben, das angibt, ob die ermittelte Induktivität zwischen den erlaubten Induktivitäten liegt.

10. Gleichstromschalter (20) nach einem der vorangehenden Ansprüche, bei dem die Steuereinrichtung (25) ausgestaltet ist, aus den ermittelten Werten die anliegende Induktivität zu ermitteln und die Ermittlung der anliegenden Induktivität mehrfach durchzuführen und eine gemittelte Induktivität zu bestimmen.

11. Gleichstromschalter (20) nach einem der vorangehenden Ansprüche, bei dem die Steuereinrichtung (25) ausgestaltet ist, aus den ermittelten Werten die lastseitig anliegende Kapazität zu ermitteln, eine Dauer für das Abfallen der Stromstärke (31) auf null nach dem Schalten in den getrennten Zustand zu bestimmen und bei der Bestimmung der lastseitig anliegenden Kapazität zu berücksichtigen.

**12.** Gleichstromschalter (20) nach einem der vorangehenden Ansprüche, bei dem die Steuereinrichtung (25) ausgestaltet ist, die lastseitig anliegende Kapazität gemäß der Formel

$$C_{load} = \frac{(Q_{load1}+Q_{load2})}{\Delta U_{out}}$$

zu berechnen, wobei $C_{load}$ die Kapazität, $Q_{load1}$ eine lastseitig im verbundenen Zustand eingetragene Ladungsmenge, $Q_{load2}$ eine lastseitig nach dem Schalten in den getrennten Zustand eingetragene Ladungsmenge und $\Delta U_{out}$ die sich durch die eingetragenen Ladungsmengen ergebende Änderung der Ausgangsspannung ist.

**13.** Gleichstromschalter (20) nach Anspruch 12, bei dem die Steuereinrichtung (25) ausgestaltet ist, die eingetragenen Ladungsmengen gemäß den Formeln

$$Q_{load1} = \frac{i_{peak}\cdot(t_{toff}-t_0)}{2}$$

$$Q_{load2} = \frac{i_{peak}\cdot(t_1-t_{off})}{2}$$

zu berechnen, wobei $t_0$ ein Einschaltzeitpunkt (34), $t_{off}$ ein Abschaltzeitpunkt (35) und $t_1$ ein Zeitpunkt, zu dem die Stromstärke nach dem Abschalten wieder null erreicht, ist.

**14.** Gleichstromschalter (20) nach Anspruch 12, bei dem die Steuereinrichtung (25) ausgestaltet ist, die eingetragenen Ladungsmengen durch numerische Integration der Stromstärke (31) zu ermitteln.

**15.** Gleichstromschalter (20) nach einem der vorangehenden Ansprüche, bei dem die Steuereinrichtung (25) ausgestaltet ist, die ermittelte lastseitig anliegende Kapazität mit einer maximal erlaubten Kapazität zu vergleichen und ein Signal auszugeben, das angibt, ob die ermittelte Kapazität größer als die maximal erlaubte Kapazität ist.

**Claims**

**1.** DC switch (20) for disconnecting a DC line (18), comprising

- at least one power semiconductor switch (21, 22) arranged in the current path of the DC line (18),
- means (28, 29) for measuring the input and output voltage (32, 33) of the DC switch (20),
- means (30) for measuring the current (31) flowing through the DC line (18),
- a control device (25) for the power semiconductor switch (21, 22),

**characterized in that** the control device (25) is configured

- to switch on the DC switch (20) for a first time period,
- to determine the present input voltage (32),
- to determine the output voltage (33) present at the end of the first time period,
- to determine the current intensity (31) present at the end of the first time period,
- to determine a present inductance and/or capacitance present on the load side from the determined values.

**2.** DC switch (20) according to Claim 1, in which the control device (25) is configured to use a duration defined prior to switch-on as the first time period.

**3.** DC switch (20) according to Claim 1, in which the control device (25) is configured to shorten the first time period and to switch off the DC switch (20) when the current intensity (31) reaches a current threshold value.

**4.** DC switch (20) according to one of the preceding claims, in which the control device (25) is configured to determine the present inductance from the determined values and to calculate the present inductance according to the formula

$$L_{supply\ line} = \frac{U \cdot t_{pulse}}{I_{peak}}$$

where $L_{supply\ line}$ is the inductance, U is a driving voltage determined from the input and/or output voltage, $t_{pulse}$ is the first time period and $I_{peak}$ is the current intensity present at the end of the first time period.

5. DC switch (20) according to one of the preceding claims, in which the control device (25) is configured to determine whether an input voltage (32) is present.

6. DC switch (20) according to one of the preceding claims, in which the control device (25) is configured to determine the output voltage (33) present at the start of the first time period.

7. DC switch (20) according to one of the preceding claims, in which the control device (25) is configured to determine the present inductance and/or capacitance before each switch-on operation.

8. DC switch (20) according to one of the preceding claims, in which the control device (25) is configured to determine the present inductance from the determined values and to compare the determined current intensity (31) with a threshold value and, based on the result of the comparison, to determine the present inductance again, wherein, instead of the first time period, a second time period that is longer than the first time period is used.

9. DC switch (20) according to one of the preceding claims, in which the control device (25) is configured to determine the present inductance from the determined values and to compare the determined present inductance with a maximum permitted inductance and a minimum permitted inductance and to output a signal indicating whether the determined inductance lies between the permitted inductances.

10. DC switch (20) according to one of the preceding claims, in which the control device (25) is configured to determine the present inductance from the determined values and to determine the present inductance multiple times and to determine an average inductance.

11. DC switch (20) according to one of the preceding claims, in which the control device (25) is configured to determine the capacitance present on the load side from the determined values, to determine a duration for the drop in the current intensity (31) to zero after switching to the disconnected state and to take it into account in the determination of the capacitance present on the load side.

12. DC switch (20) according to one of the preceding claims, in which the control device (25) is configured to calculate the capacitance present on the load side according to the formula

$$C_{load} = \frac{(Q_{load1} + Q_{load2})}{\Delta U_{out}}$$

where $C_{load}$ is the capacitance, $Q_{load1}$ is a quantity of charge input on the load side in the connected state, $Q_{load2}$ is a quantity of charge input on the load side after switching to the disconnected state and $\Delta U_{out}$ is the change in the output voltage resulting from the input quantities of charge.

13. DC switch (20) according to Claim 12, in which the control device (25) is configured to calculate the input quantities of charge according to the formulae

$$Q_{load1} = \frac{\overline{i_{peak}} \cdot \left(\overline{t_{toff}} - t_0\right)}{2}$$

$$Q_{load2} = \frac{i_{peak} \cdot \left(t_1 - t_{off}\right)}{2}$$

where $t_0$ is a switch-on time (34), $t_{off}$ is a switch-off time (35) and $t_1$ is a time at which the current intensity reaches zero again after switch-off.

14. DC switch (20) according to Claim 12, in which the control device (25) is configured to determine the input quantities of charge by numerical integration of the current intensity (31).

15. DC switch (20) according to one of the preceding claims, in which the control device (25) is configured to compare the determined capacitance present on the load side with a maximum permitted capacitance and to output a signal indicating whether the determined capacitance is greater than the maximum permitted capacitance.

**Revendications**

1. Interrupteur (20) à courant continu pour le sectionnement d'une ligne (18) de courant continu, comprenant

   - au moins un interrupteur (21, 22) à semiconducteur de puissance monté dans le chemin de courant de la ligne (18) de courant continu,
   - des moyens (28, 29) de mesure de la tension (32, 33) d'entrée et de sortie de l'interrupteur (20) à courant continu,
   - des moyens (30) de mesure du courant (31) passant dans la ligne (18) de courant continu,
   - un dispositif (25) de commande de l'interrupteur (21, 22) à semiconducteur de puissance,

   **caractérisé en ce que** le dispositif (25) de commande est conformé,

   - pour fermer l'interrupteur (20) de courant continu pendant un premier laps de temps,
   - pour déterminer la tension (32) d'entrée appliquée,
   - pour déterminer la tension (33) de sortie présente à la fin du premier laps de temps,
   - pour déterminer l'intensité (31) du courant présente à la fin du premier laps de temps,
   - pour à partir des valeurs déterminées, déterminer une inductance appliquée et/ou une capacité appliquée du côté de la charge.

2. Interrupteur (20) à courant continu suivant la revendication 1, dans lequel le dispositif (25) de commande est conformé, pour utiliser comme premier laps de temps, une durée fixée avant la fermeture.

3. Interrupteur (20) à courant continu suivant la revendication 1, dans lequel le dispositif (25) de commande est conformé, pour écourter le premier laps de temps et ouvrir l'interrupteur (20) à courant continu, si l'intensité (31) du courant atteint une valeur de seuil de courant.

4. Interrupteur (20) à courant continu suivant l'une des revendications précédentes, dans lequel le dispositif (25) de commande est conformé, pour à partir des valeurs déterminées, déterminer l'inductance appliquée et pour calculer l'inductance appliquée suivant la formule $L_{zuleitung} = \frac{U \cdot t_{puls}}{I_{peak}}$ ,

   dans lequel $L_{zuleitung}$ est l'inductance, U une tension d'attaque déterminée à partir de la tension d'entrée et/ou de la tension de sortie, $t_{puls}$ le premier laps de temps et $I_{peak}$ l'intensité du courant présente à la fin du premier laps de temps.

5. Interrupteur (20) à courant continu suivant l'une des revendications précédentes, dans lequel le dispositif (25) de commande est conformé, pour déterminer si une tension (32) d'entrée s'applique.

6. Interrupteur (20) à courant continu suivant l'une des revendications précédentes, dans lequel le dispositif (25) de commande est conformé, pour déterminer la tension (33) de sortie présente au début du premier laps de temps.

7. Interrupteur (20) à courant continu suivant l'une des revendications précédentes, dans lequel le dispositif (25) de commande est conformé, pour effectuer une détermination de l'inductance et/ou de la capacité appliquée avant chaque opération de fermeture.

8. Interrupteur (20) à courant continu suivant l'une des revendications précédentes, dans lequel le dispositif (25) de commande est conformé, pour à partir des valeurs déterminées, déterminer l'inductance appliquée et pour comparer l'intensité (31) du courant déterminée à une valeur de seuil et sur la base du résultat de la comparaison pour déterminer à nouveau l'inductance appliquée, dans lequel on utilise au lieu du premier laps de temps un deuxième laps de temps, qui est plus long que le premier laps de temps.

9. Interrupteur (20) à courant continu suivant l'une des revendications précédentes, dans lequel le dispositif (25) de commande est conformé, pour à partir des valeurs déterminées, déterminer l'inductance appliquée et pour comparer l'inductance appliquée déterminée à une inductance permise au maximum et à une inductance permise au minimum et pour émettre un signal, qui indique si l'inductance déterminée se trouve entre les inductances permises.

10. Interrupteur (20) à courant continu suivant l'une des revendications précédentes, dans lequel le dispositif (25) de commande est conformé, pour à partir des valeurs déterminées, déterminer l'inductance appliquée et pour effectuer plusieurs fois la détermination de l'inductance appliquée et pour déterminer une inductance en moyenne.

11. Interrupteur (20) à courant continu suivant l'une des revendications précédentes, dans lequel le dispositif (25) de commande est conformé, pour à partir des valeurs déterminées, déterminer la capacité appliquée du côté de la charge, déterminer une durée pour la décroissance de l'intensité (31) du courant à zéro après la mise dans l'état sectionné et pour tenir compte, lors de la détermination, de la capacité appliquée du côté de la charge.

12. Interrupteur (20) à courant continu suivant l'une des revendications précédentes, dans lequel le dispositif (25) de commande est conformé, pour calculer la capacité appliquée du côté de la charge suivant la formule,

$$C_{load} = \frac{(Q_{load1} + Q_{load2})}{\Delta U_{out}}$$

dans laquelle $C_{load}$ est la capacité, $Q_{load1}$ une quantité de charge enregistrée dans l'état connecté du côté de la charge, $Q_{load2}$ une quantité de charge enregistrée dans l'état du côté de la charge après la mise dans l'état sectionné et $\Delta U_{out}$ la variation de la tension de sortie provenant des quantités de charges enregistrées.

13. Interrupteur (20) à courant continu suivant la revendication 12, dans lequel le dispositif (25) de commande est conformé, pour calculer les quantités de charge enregistrées suivant les formules,

$$Q_{load1} = \frac{i_{peak} \cdot (t_{toff} - t_0)}{2}$$

$$Q_{load2} = \frac{i_{peak} \cdot (t_1 - t_{off})}{2}$$

dans lesquelles $t_0$ est un instant (34) de fermeture, $t_{off}$ un instant (35) d'ouverture et $t_1$ un instant où l'intensité du courant atteint à nouveau zéro après l'ouverture.

14. Interrupteur (20) suivant la revendication 12, dans lequel le dispositif (25) de commande est conformé, pour déterminer les quantités de charge enregistrées par intégration numérique de l'intensité (31) du courant.

15. Interrupteur (20) suivant l'une des revendications précédentes, dans lequel le dispositif (25) de commande est conformé, pour comparer la capacité déterminée appliquée du côté de la charge à une capacité permise au maximum et pour émettre un signal, qui indique si la capacité déterminée est plus grande que la capacité permise au maximum.

FIG 1

FIG 2

FIG 3

**IN DER BESCHREIBUNG AUFGEFÜHRTE DOKUMENTE**

**In der Beschreibung aufgeführte Patentdokumente**

- WO 2019237221 A1